# EUROPEAN PATENT APPLICATION

(11) **EP 3 716 312 A1**
(43) Date of publication of application: **30.09.2020**
(21) Application number: 19165969.7
(22) Date of filing: 28.03.2019
(51) Int. Cl.: H01J 37/244, H01J 37/28

(54) **CHARGED PARTICLE BEAM DEVICE FOR INSPECTION OF A SPECIMEN WITH A PLURALITY OF CHARGED PARTICLE BEAMLETS**

(71) Applicant: FEI Company, Hillsboro, OR 97124-5793 (US)
(72) Inventor: Hlavenka, Petr, 5602 BS Eindhoven (NL); Sed'a, Bohuslav, 5602 BS Eindhoven (NL)
(74) Representative: Janssen, Francis-Paul

(57) **Abstract**

The invention relates to a charged particle beam device for inspection of a specimen with a plurality of charged particle beamlets. The charged particle beam device comprises a specimen holder for holding a specimen, a source for producing a beam of charged particles, and an illuminator for converting said beam of charged particles into a plurality of charged particle beamlets and focusing said plurality of charged particle beamlets onto said specimen. Furthermore, a detector assembly for detecting a flux of radiation emanating from the specimen in response to said irradiation by said plurality of charged particle beamlets is provided. As defined herein, the charged particle beam device is arranged for directing said plurality of charged particle beamlets onto said specimen in an essentially 1D pattern, wherein said essentially 1D pattern forms part of an edge of an essentially 2D geometric shape. Furthermore, the detector assembly comprises a plurality of detector units arranged in a corresponding essentially 1D pattern.

## Description

The invention relates to a charged particle beam device for inspection of a specimen with a plurality of charged particle beamlets, the charged particle beam device comprising:
- A specimen holder for holding a specimen;
- A source for producing a beam of charged particles;
- An illuminator for converting said beam of charged particles into a plurality of charged particle beamlets and focusing said plurality of charged particle beamlets onto said specimen; and
- A detector assembly for detecting a flux of radiation emanating from the specimen in response to said irradiation by said plurality of charged particle beamlets.

In known systems, the illuminator comprises a multi-aperture lens plate having a grid of apertures for defining the corresponding plurality of charged particle beamlets. The aperture array typically plays a double role. First, the apertures define the individual beamlets as they are cut out of a single, large beam that is emitted by (for example) a field emitter gun. Hence, they serve as beam limiting apertures for the individual beamlets. Second, if there is an electric field at least on one side of the plate, and a different field on the other side, then the individual apertures serve as (micro) lenses for the beamlets. Hence, (virtual) crossovers are created for the beamlets in a different plane than the common crossovers for the beam as a whole. This allows (for example) to focus the beamlets as probes on a specimen in a regular two-dimensional pattern. Alternatively, a different aperture array can be used for the lensing than the one that is used for the beam definition.

The multi-beamlet device described above generally provides satisfactory results. However, for backscattered electron detection the present design provides some challenges. For various reasons, it would be desirable to be able to accurately detect backscattered electrons (BSEs) in such tools. For example, BSEs generally come from greater sub-surface depths than secondary electrons, and they therefore provide more depth-related information. BSE yield values also give information on the atomic number constitution of the specimen. Also, BSEs tend to show preferential energies and/or emission angles as a function of depth, and can therefore serve as a useful basis for performing tomography. However, in the case of multi-beam EMs, BSE fluxes (with associated information) precipitated by the various input beams tend to become mixed/jumbled just a short distance above the specimen surface, e.g. of the order of just a few microns for typical beam array configurations (such as 14x14 beams at (specimen-level) orthogonal separations of ca. 3 µm, for example). Consequently, if a conventional BSE detection architecture is used, it will basically register a convoluted mix of BSEs. Hence, one of the challenges in backscattered electron detection, especially in these multi-beamlet devices, exists in correctly assigning detected backscattered electrons to the corresponding beamlet.

From this point of view it is an object to provide a charged particle beam device with improved detector functionalities. It is in particular an object to provide a charged particle beam device with which individual beamlet backscatter electron detection is possible.

To this end, a charged particle beam device for inspection of a specimen with a plurality of charged particle beamlets is provided as defined in claim 1. As defined herein, the charged particle beam device comprises a specimen holder for holding a specimen, a source for producing a beam of charged particles, and an illuminator for converting said beam of charged particles into a plurality of charged particle beamlets, as well as for focusing said plurality of charged particle beamlets onto said specimen. Further, the charged particle beam device comprises a detector assembly for detecting a flux of radiation emanating from the specimen in response to said irradiation by said plurality of charged particle beamlets.

According to the invention, the charged particle beam device is arranged for directing said plurality of charged particle beamlets onto said specimen in an essentially 1D (one dimensional) pattern. Said essentially 1D pattern forms part of an edge of an essentially 2D geometric shape. The essentially 1D pattern can be a line, but can also be a spline, a curve, a circle, or combinations thereof. According to the disclosure, the plurality of charged particle beamlet spots are arranged in such a way that they are all positioned on an outer boundary or circumference of an essentially 2D (two-dimensional) geometric shape. The geometric shape can be a rectangle, square, triangle, circle, or the like.

According to the invention, the detector assembly comprises a plurality of detector units positioned in a corresponding essentially 1D pattern, wherein each detector unit is arranged for detecting a flux of radiation emanating from the specimen in response to irradiation by an associated one of said plurality of charged particle beamlets.

By directing the plurality of charged particle beamlets onto said specimen in an essentially 1D pattern, wherein said essentially 1D pattern forms part of an edge of an essentially 2D geometric shape, it is possible to use a corresponding essentially 1D pattern for the plurality of detector units as well. This configuration provides a lot of design freedom, in particular to the design options for the detector units, as the essentially 1D pattern allows direct access to the small active surface adjoint to each beamlet. First of all, this configuration provides a lot of room for the detector units, as they can be positioned outside of the outer edge of the 2D geometric shape and all the space in radial direction and vertical direction maybe utilized for parallel detector construction. Secondly, design restrictions are alleviated, as the detector units do not need to reach in between two adjacent first and second beamlets to reach a third, more internal, beamlet, as would be required in prior art multi-beamlet devices with their grid-like beamlet patterns. With the essentially 1D pattern, no complex construction is needed to be able to position the detector units close to the corresponding charged particle beamlet. With this, the object as defined herein is achieved.

Further advantageous embodiments will be discussed below.

In an embodiment, said essentially 1D pattern comprises a straight line. Said essentially 1D pattern may additionally, or alternatively comprise a curved line. Said essentially 1D pattern may comprise a semi-circle or a (part of a) circle. These are all geometries that provide space advantages, and allow a compact design with respect to the detector units as well. In case of a semi-circle or (part of a) circle, it is advantageous when the charged particle beamlets are placed substantially equidistant from an optical axis of the charged particle beam device. This way, the beamlets all exhibit essentially the same optical aberrations, which can be counteracted, if desired, in a uniform manner.

In an embodiment, the charged particle beam device is arranged for scanning said sample with said plurality of charged particle beamlets. This allows a larger part of the specimen to be investigated in an effective manner.

An effective scanning of said sample may be obtained when said charged particle beam device is arranged for reciprocal movement of the plurality of charged particle beamlets in a first direction, as well as for reciprocal movement of the specimen holder in a second direction that is substantially orthogonal to the first direction. This way, the specimen may be moved in the second direction, e.g. from left to right, whilst concurrently the beamlets can be moved back and forth, i.e. in a reciprocal manner, in the first direction, e.g. up and down. This allows for a large area of the sample to be scanned in a quick and effective manner. It will be clear that alternative movement schemes are conceivable as well. For example, the sample may be moved in a reciprocal manner, whilst the beamlets are moved from up to down. It is noted that during movement of the charged particle beamlets in the first direction, and movement of the specimen holder in the second direction, additional movement of the charged particle beamlets in the second direction and/or additional movement of the specimen holder in the first direction is conceivable as well, to allow for drift corrections, distortion corrections and the like.

In an embodiment, said detector assembly is a BSE detector assembly, comprising a plurality of BSE detector units.

In an embodiment, at least one of the plurality of detector units comprises a housing having a front end surface that is directed to a corresponding charged particle beamlet, as well as a bottom surface that is directed to said sample. The set-up allows the detector unit to be positioned relatively close to the corresponding charged particle beamlet, which aids in assigning the detected signal to the correct charged particle beamlet.

In an embodiment, said bottom surface comprises a detector element for detecting said flux of radiation emanating from the specimen in response to irradiation by said corresponding charged particle beamlet.

The detector element may alternatively, or additionally, said front end surface comprises a detector element.

Said detector element may comprise a scintillation layer and/or a monocrystalline scintillator.

In an embodiment, said detector element comprises a photonic sensor or solid state direct electron sensor.

In an embodiment, said detector unit comprises a lightguide element for direct light coupling of said detector element. Said lightguide element may be arranged for direct light coupling of said scintillation layer to said photonic sensor.

In another embodiment, a monocrystalline scintillator is used that functions as the detector element and the lightguide element. The monocrystalline scintillator can be in contact with the photonic sensor or solid state direct electron sensor.

It is conceivable that the lightguide element extends over a distance of at least 5 mm, in particular at least 10 mm.

When a scintillation layer is used, the approach of using an essentially 1D pattern allows for direct light coupling from the scintillator to a photonic sensor via a lightguide element. In case a circle or semi circle 1D pattern is used for the plurality of beamlets -and hence for the detector units as well- this allows the lightguide to occupy a constant sector of a circle (constant angle), which allows the lightguide to expand from microns-sized dimensions into millimetres after approximately 10 mm distance from the optical axis. This enables the use of discrete photodiodes/photomultipliers for each beamlet channel. With this a higher speed (> 1 MHz) compared to CMOS cameras (up to kHz) can be obtained. Additionally, the discrete sensors, such as PMT or SiPM, offer favourable macroscopic dimensions. A similar advantage exists when a monocrystalline scintillator is used, as the monocrystalline scintillator acts as the lightguide element. All in all, the design as presented herein offers better light collection using the lightguide element and significantly easier alignment and robustness and complexity-reduction using a monolithic detection element, without having to resort to complicated and challenging detector assemblies.

In case of a different approach where a silicon-based sensor is used, the 1D-pattern (linear or circular) can be advantageously used for simple routing of signal lines from each detection areas, which would not be possible in the tightly packed 2D grid as used in the prior art.

According to an aspect, a method of inspecting a specimen with a plurality of charged particle beamlets is provided, the method comprising the steps of:
- Providing a specimen;
- Providing a plurality of charged particle beamlets and focusing said plurality of charged particle beamlets onto said specimen;
- Detecting a flux of radiation emanating from the specimen in response to said irradiation by said plurality of charged particle beamlets.

As described herein, the method comprises the steps of:
- Directing said plurality of charged particle beamlets onto said specimen in an essentially 1D pattern; and
- Detecting a flux of radiation emanating from the specimen in response to irradiation by an associated one of said plurality of charged particle beamlets.

In an embodiment, said detecting is in particular done using a plurality of detector units that are arranged in a corresponding essentially 1D pattern.

Advantages of such a method have been explained above by reference to a charged particle beam device as disclosed herein. The method may be executed with a charged particle beam device as described herein.

Advantageous embodiments will be explained below.

In an embodiment, the method comprises the step of scanning said sample with said charged particle beamlets, in particular by moving said charged particle beamlets onto said specimen in a first direction and concurrently moving said specimen in a second direction substantially orthogonal to said first direction.

In an embodiment, detecting a flux of radiation comprises the step of detecting backscattered electrons.

In an embodiment, the distance between the detector and the specimen is kept constant during inspecting said specimen. Additionally, the distance between the detector and the beamlets may be kept constant during inspection. Distance may be kept constant by moving the stage. Other ways of achieving this result are conceivable as well.

In an embodiment, a mutual position of the plurality of charged particle beamlets and the corresponding plurality of detector elements is aligned. This way, the center of the detector element and the central position of the beamlet match in tangential direction, and the perpendicular distance of the detector element edge and the beamlet can be kept small and substantially constant during system operation.

The invention will now be elucidated in more detail on the basis of exemplary embodiments and the accompanying schematic drawings, in which:
Fig. 1 - renders a longitudinal cross-sectional elevation view of an embodiment of an electron microscope in which the present invention is implemented.
Fig. 2 - illustrates a manner in which an electron beam array can be generated from a single progenitor beam, according to a prior art arrangement.
Fig. 3 - illustrates a manner in which a 1D pattern of a plurality of charged particle beamlets can be generated, according to a first embodiment.
Fig. 4 - illustrates a manner in which a 1D pattern of a plurality of charged particle beamlets can be generated, according to a second embodiment.
Fig. 5 - illustrates a manner in which a 1D pattern of a plurality of charged particle beamlets can be generated, according to a third embodiment.
Fig. 6 - illustrates a manner in which a sample can be inspected, using a 1D pattern of a plurality of charged particle beamlets;
Fig. 7 - shows a top view and side (cross-sectional) view of a detector assembly and detector unit thereof;
Fig. 8 - shows a perspective view of a detector according to an embodiment.

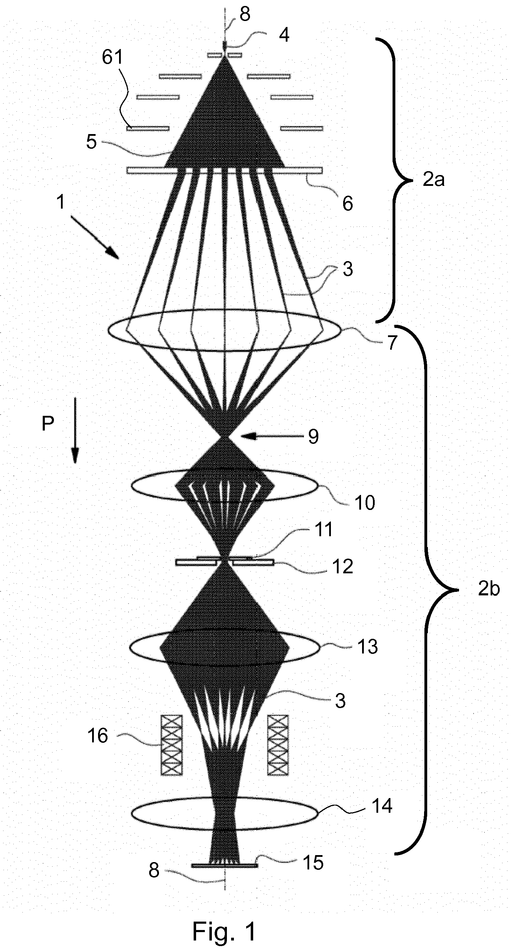

Figure 1 shows an example of a charged particle beam device, in the form of a Multi-Beam Scanning Electron Microscope (MBSEM). The MBSEM 1 comprises a multi beam charged particle generator 2a for generating an array of primary charged particle beams 3, in this case an array of primary electron beams 3. The multi beam electron generator 2a comprises at least one electron source 4 for generating a diverging electron beam 5. The diverging electron beam 5 is split into an array of focused primary electron beams 3 by an aperture lens array 6. The primary electron beams 3 are subsequently directed towards a sample 15, as schematically indicated by the arrow P. The sample can be positioned on a stage, so that it can be positioned in a desired manner with respect to the charged particle beamlets 3.

The multiple images of the source 4 are positioned on the object principle plane of an accelerator lens 7. The accelerator lens 7 directs the primary electron beams 3 towards the optical axis 8 and creates a first common cross-over 9 of all the primary electron beams 3.

The first common cross-over 9 is imaged by the magnetic condenser lens 10 onto a variable aperture 11 that acts as a current limiting aperture. At the variable aperture 11 a second common cross-over of all the primary electron beams 3 is created.

The MBSEM comprises a lens system 13, 14 for directing the primary charged particle beams from the common cross-over at the variable aperture 11 towards the sample surface 15 and for focusing all primary charged particle beams 3 into an array of individual spots on the sample surface 15. The lens system comprises an intermediate magnetic lens 13 for imaging the variable aperture 11 onto a coma free plane of the objective lens 14, which objective lens 14 creates an array of focused primary electron beams on the sample surface 15.

In addition the MBSEM is provided with scan coils 16 for scanning the array of focused primary electron beams over the sample surface 15.

The MBSEM shown in this embodiment is furthermore provided with a position sensitive secondary electron detector 12 positioned at least substantially in or near a plane comprising a common cross-over, in this case directly below the variable aperture 11. This secondary electron detection system 12 is arranged to acquire the individual secondary electron image of each single primary electron beam spot on the sample surface 15. This means, that when the sample surface 15 is scanned in this MBSEM 1, multiple images can be acquired at the same time in one single scan period.

The charged particle beam device 1 as shown in Fig. 1 is arranged for inspection of a specimen 15 with a plurality of charged particle beamlets 3. The charged particle beam device comprises a specimen holder 15 for holding a specimen; a source 4 for producing a beam 5 of charged particles; an illuminator 2b for converting said beam 5 of charged particles into a plurality of charged particle beamlets 3 and directing said plurality of charged particle beamlets 3 onto said specimen 15. The illuminator 2b comprises a multi-aperture lens plate 6 having a plurality of apertures for defining the corresponding plurality of charged particle beamlets; as well as at least a first electrode 61 for generating an electrical field at a surface of the multi-aperture lens plate 6; and a detector 12 for detecting a flux of radiation emanating from the specimen 15 in response to said irradiation by said plurality of charged particle beamlets. It is noted that the general setup as shown here in Fig. 1 is known to those skilled in the art, for example from EP 2 864 997 B1, and modifications to this set up are known to those skilled in the art as well.

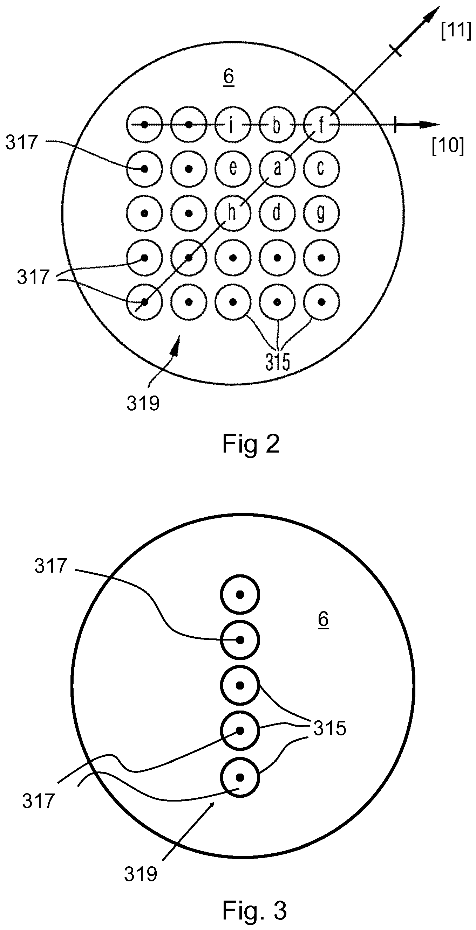

The charged particle device 1 as disclosed herein comprises a multi-aperture lens plate 6, wherein the apertures in said multi-aperture lens plate 6 have a noncircular cross-sectional shape. This will be discussed in more detail with respect to several embodiments as shown in Fig. 2 to Fig. 7. With the multi-aperture lens plate, imaging resolution is improved.

Figure 2 shows a regular grid 319 of apertures 315 formed in a multi-aperture plate 6 according to the prior art. Each non-peripheral aperture, or central aperture, "a" has four directly neighbouring apertures "b", "c", "d" and "e", and it has four second closest neighbouring apertures, or diagonally neighbouring, "f', "g", "h" and "i". Figure 2 indicates a basic array vector [10] in which apertures 315 are arrayed at the closest neighbour pitch, and Figure 2 indicates a basic array vector [11] in which the apertures 315 are arrayed with a second closest neighbour pitch. Each aperture has a center 317. The apertures shown here are arranged in a 5 x 5 matrix, having external apertures i, b, f, c, g positioned on a contour or edge of the grid, and internal apertures e, a, h, d positioned within an interior of the grid. Using such an aperture plate 6, a convoluted mix of BSEs is detected in case conventional BSE detection architecture is used. As indicated previously, one of the challenges in backscattered electron detection, especially in these multi-beamlet devices, exists in correctly assigning detected backscattered electrons to the corresponding beamlet.

Fig. 3 shows a setup according to an embodiment of the disclosure. Here, the multi-aperture plate 6 comprises plurality of apertures 315 that are arranged to form a line. With the multi-aperture plate 6 the charged particle beam device is able to direct said plurality of charged particle beamlets onto said specimen in an essentially 1D pattern, in this case in the form of a straight line. Due to this essentially 1D pattern, it is possible to arrange the detector assembly to comprise a plurality of detector units arranged in a corresponding essentially 1D pattern, with each detector unit positioned relatively close to the corresponding beamlet such that the detected signal can be correctly assigned to the corresponding charged particle beamlet.

In Fig. 3, the essentially 1D pattern comprises a straight line. It could alternatively be a curved line. The essentially 1D pattern is arranged in such a way that the pattern is free from internal apertures. The use of internal apertures, such as internal apertures e, a, h, d as shown in Fig. 2, makes it relatively hard to discern a first flux of radiation emanating from the specimen in response to irradiation by a first charged particle beamlet, from a second, neighbouring, flux of radiation emanating from the specimen in response to irradiation by a second, neighbouring, charged particle beamlet. To be able to do this, would require the individual detector units to be arranged relatively close to the specimen, and relatively close to the charged particle beamlet as well. Especially for internal apertures this is difficult, as the available room for placing a detector unit is too small. According to the present disclosure, however, the above requirements can be met when the plurality of charged particle beamlets form an essentially 1D pattern, in particular wherein said essentially 1D pattern forms part of an edge of an essentially 2D geometric shape. The 2D geometric shape can be a square, rectangle, triangle, circle, or parts thereof. This allows all detector units to approach the sample and the corresponding charged particle beamlet from the side, i.e. from the outer contour of the essentially 2D geometric shape. This way, the detector unit can be positioned close enough to the sample, and close enough to the corresponding beamlet, to ensure that the detected signal is emanating from the corresponding charged particle beamlet. This is in particular advantageous when said detector assembly is a Back Scatter Electron (BSE) detector assembly, comprising a plurality of BSE detector units. The plurality of detectors may be arranged in a corresponding 1D pattern as well, or may be arranged in a different 1D pattern. For example, in the embodiment of Fig. 3, it is conceivable that the detector units are arranged in an alternating fashion, e.g. alternating on both (left and right) sides of the charged particle beamlets. This results in a zig-zag 1D pattern for the detector units. It is also possible to use two dedicated detector elements each from a different side to collect signal generated by the very same beamlet and thus enhancing the signal collection efficiency and improving the image SNR.

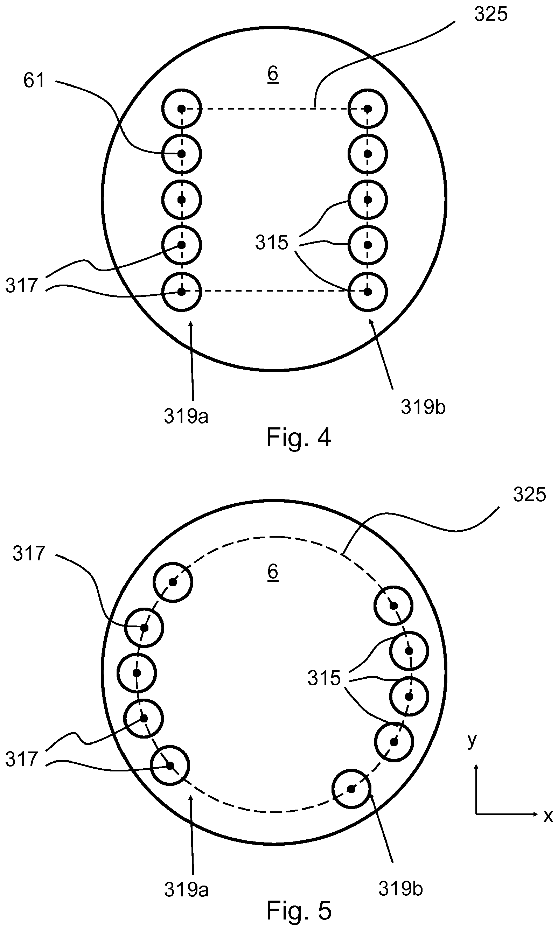

Now turning to Fig. 4, a further embodiment of a multi-aperture plate is shown, allowing the charged particle beam device as disclosed herein to direct said plurality of charged particle beamlets onto said specimen in an essentially 1D pattern. Here, the multi-aperture plate comprises two rows 319a, 319b of apertures 315, that are positioned side by side. In the embodiment shown, the essentially 1D pattern forms part of an edge of a square or rectangle 325 (dotted line). With the essentially 1D pattern as shown here, it is once again possible to arrange the detector units in a corresponding essentially 1D pattern, to allow reliable detection of a flux of radiation emanating from the specimen in response to irradiation by an associated one of said plurality of charged particle beamlets. In this case, detectors associated with the first row 319a can be positioned on the left hand side of the drawing, and detectors associated with the second row 319b can be positioned on the right hand side of the drawing.

In the embodiments of Fig. 3 and Fig.4, it is referred to a multi-aperture plate 6 for defining the essentially 1D pattern of charged particle beamlets. It will be understood by those skilled in the art, that other ways of achieving this essentially 1D pattern are possible as well. Further, in Fig. 3, a total of five apertures are used, and in Fig. 4 a total of ten apertures are used. it is conceivable however that any number of apertures are used in the essentially 1D pattern.

It is further more conceivable that the desired 1D pattern is obtained by blocking a number of apertures in a multi-aperture plate 6. For example, in the prior art aperture plate 6 as shown in Fig. 2, it is conceivable that the beamlets coming from internal apertures (e.g. e, a, h, d) are blocked, and cannot reach the specimen. In that case the beamlets reaching the sample are able to form an essentially 1D pattern, defined by the outer contour of an essentially 2D geometric shape (in this case, a square), which allows detector units to be positioned in a corresponding 1D pattern as well.

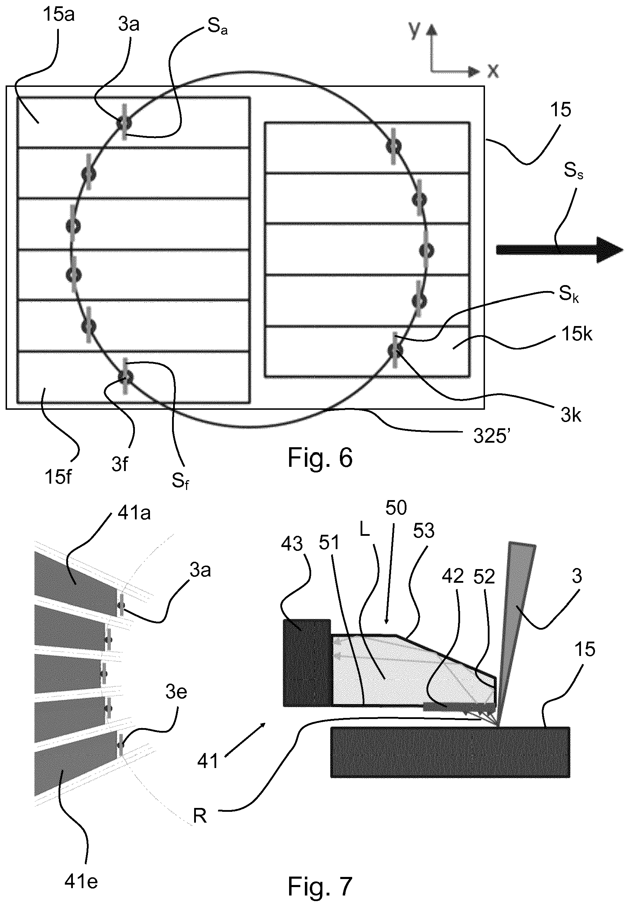

Now turning to Fig. 5, a further embodiment of a multi-aperture plate is shown, allowing the particle beam device as disclosed herein to direct said plurality of charged particle beamlets onto said specimen in an essentially 1D pattern. Here, the essentially 1D pattern comprises two sub-parts of a circle 325. In that sense, the arrangement is quite similar to the two row linear arrangement of Fig. 4, although two main differences exist: first, the two rows 319a, 319b used in Fig. 5 are arranged on circle 325, i.e. they are positioned on the outer contour or outline of the 2D geometric shape (which, in this case, is a circle 325). Second, the second row 319b has a slight offset with respect to the first row 319a. Fig. 5 shows a coordinate axis x,y to illustrate this. The second row 319b is slightly offset in (minus) y-direction compared to the first row 319a. In particular, the offset is such that a given aperture of the first row 319a is in between adjacent apertures of the second row 319b. This strategy is applicable to the embodiment of Fig. 4 as well. This off-set or staggering arrangement has several advantages in effectively and efficiently scanning the sample, as will be discussed next with respect to Fig. 6. It is noted that in a single row, adjacent apertures preferably have the same distance in y-direction, although the distance in x-direction may vary in this case as the apertures are essentially placed on the outer contour of circle 325.

Now referring to Fig. 6, a schematic top view of the charged particle beamlet arrangement described herein is shown. It is shown a schematic top view of the sample 15, comprising a plurality of sample regions Sₐ-Sₖ. It is noted here that not all sample regions are provided with a reference numeral, for clarity purposes. Each sample region Sₐ-Sₖ has an associated charged particle beamlet 3a-3k. The sample 15 can be moved in the positive (and negative) x-direction (indicated by arrow Sₛ). The charged particle beamlets can be moved in positive and negative y-direction. Additional movements of the sample and the beamlets is conceivable as well. Hence, the charged particle beam device is arranged for scanning said sample with said plurality of charged particle beamlets. The scanning path Sₐ-Sₖ of a single beamlet is indicated in Fig. 6. By moving the sample in a single direction Sₛ and concurrently moving the beamlets 3a-3k. up and down (substantially orthogonal to the sample movement direction) in a reciprocal manner, it is possible to scan a relatively large portion of the sample 15 in a quick, effective and reliable manner. The placement of the beams in a 1D pattern in the form of the outline of a circle, ensures that detector units can be placed near to the respective beamlets (see Fig. 7), but also ensures that aberrations are minimized.

Now turning to Fig. 7, the positioning of the detector units 41a-41e with respect to the charged particle beamlets 3a-3e is shown in het left hand part of the figure, and a cross-sectional view of a single detector unit 41 is shown in the right hand part of the figure. It can be seen that the charged particle beamlets 3a-3e are positioned in the form of part of a circle. It is noted that the left part of the Fig. 7 only shows a part of the setup, and the complete setup could be similar to the setup shown in Fig. 6. However, it is also conceivable that the setup as shown in one or more of Fig. 3-5 is used. In all events, however, the individual detector units 41 can be positioned relatively close to the sample 15, as well as close to the corresponding charged particle beamlet 3a-3e. With the setup as disclosed herein, the detector units 41a-41e can approach the corresponding charged particle beamlet from an outer part of the outer contour of the essentially 2D geometric shape (which, in the embodiment shown is a circle). As mentioned before, the essentially 2D geometric shape can be a square, rectangle, triangle, semi-circle, circle, or any other shape, or parts or combinations thereof. Due to the detectors being able to approach the outer contour of the 2D geometric shape defined by the particle beamlets 3a-3e, there is sufficient space available to embody the detector units. In other words, the 1D pattern defined by the charged particle beamlets relieves the space constraints for the corresponding detector units.

The cross-section of Fig. 7 shows a single charged particle beamlet 3 impinging on the surface of the sample 15, thereby generating a flux of radiation R. A detector unit 41 is positioned close to the surface of the sample, and close to the charged particle beamlet 3. The detector unit 41 comprises a housing 50, with a front end surface 52 that is directed to the corresponding charged particle beamlet 3, as well as a bottom surface 51 that is directed to said sample. The housing comprises a top surface 53 as well. The front end surface 52 connects the bottom surface 51 to the top surface 53. A further circumferential wall (not shown) can be provided as well. In the embodiment shown, the bottom surface 51 comprises a detector element 42 for detecting said flux of radiation R emanating from the specimen 15 in response to irradiation by said corresponding charged particle beamlet 3. Alternatively, or additionally, the front end surface 52 may be provided with such a detector element 42. The detector element can be a relatively thin layer of scintillation material.

In the embodiment shown, the detector 41 comprises a light guide L formed inside the housing 50 and arranged for direct light coupling of said detector element. The light guide can either be an empty space inside a polished reflective "housing", or a glass part where the light is propagated through the glass and reflected from the light-vacuum boundary by total reflection. In the embodiment shown, light is coupled from the sensor surface 42 to a Photonic sensor 43. The sensor surface 42 can be a thin scintillator layer. In an embodiment, the sensor 42 can be a solid state direct electron sensor.

In an alternative embodiment, the housing 50 can be made from transparent material e.g. glass and act as lightguide L and detector element 42 can be a thin layer of scintillation material placed on the light-guide surface and a photonic sensor 43 coupled to it.

In an alternative embodiment, the housing 50 with detector element 42 can be a monocrystalline scintillator with functionality of sensor surface 42, which also acts as the light guide L for coupling to the photonic sensor 43.

In an alternative embodiment, the housing 50 carries a solid state direct electron sensor 42. In that case, sensor element 43 can be absent.

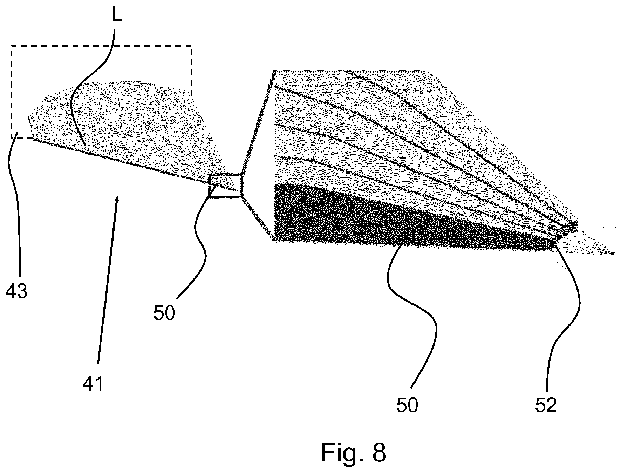

Referring now to Fig. 8, a setup of the detector assembly with a total of five individual detector units 41 is shown. Here, the micro- to macro-scale span enabled by matching the 1D arrangement of the detector units 41 to the 1D pattern of the charged particle beamlets is visualized. The beamlets are arranged on the outer contour of a circle as 2D geometric shape, having a diameter of approximately 100 µm. The lightguide L connects the front end of the detector unit to an array of individual sensors 43 (schematically indicated here by dashed line). The length of the lightguide L shown here is approximately 10 mm, and the end face near the sensor 43 is approximately 2mm wide, enabling good detector-sensor coupling. In other embodiments, where a silicon-based sensor is used, the 1D pattern (linear, square or circular) can be leveraged for simple routing of signal lines from each detection area. This would not be possible in the tightly packed 2D array of charged particle beamlets that is used in the prior art.

Above, several embodiments have been discussed with respect to the accompanying Figs. The desired protection is determined by the appended claims.

## Claims

1. A charged particle beam device for inspection of a specimen with a plurality of charged particle beamlets, the charged particle beam device comprising:
- A specimen holder for holding a specimen;
- A source for producing a beam of charged particles;
- An illuminator for converting said beam of charged particles into a plurality of charged particle beamlets and focusing said plurality of charged particle beamlets onto said specimen;
- A detector assembly for detecting a flux of radiation emanating from the specimen in response to said irradiation by said plurality of charged particle beamlets;
**Characterized in that**
- Said charged particle beam device is arranged for directing said plurality of charged particle beamlets onto said specimen in an essentially 1D pattern, wherein said essentially 1D pattern forms part of an edge of an essentially 2D geometric shape;
- Said detector assembly comprises a plurality of detector units arranged in a corresponding essentially 1D pattern, wherein each detector unit is arranged for detecting a flux of radiation emanating from the specimen in response to irradiation by an associated one of said plurality of charged particle beamlets.

2. A charged particle beam device according to claim 1, wherein said essentially 1D pattern comprises a straight line and/or a curved line, in particular wherein said essentially 1D pattern comprises a semi-circle or a circle.

3. A charged particle beam device according to claim 1 or 2, wherein said charged particle beam device is arranged for scanning said sample with said plurality of charged particle beamlets.

4. A charged particle beam device according to claim 3, wherein said charged particle beam device is arranged for reciprocal movement of the plurality of charged particle beamlets in a first direction, as well as for reciprocal movement of the specimen holder in a second direction that is substantially orthogonal to the first direction.

5. A charged particle beam device according to any one of the previous claims, wherein said detector assembly is a Back Scatter Electron (BSE) detector assembly, comprising a plurality of BSE detector units.

6. A charged particle beam device according to claim 1-5, wherein the detector unit comprises a housing having a front end surface that is directed to a corresponding charged particle beamlet, as well as a bottom surface that is directed to said sample, wherein in particular at least one of said bottom surface and said front end surface comprise a detector element for detecting said flux of radiation emanating from the specimen in response to irradiation by said corresponding charged particle beamlet.

7. A charged particle beam device according to claim 6, wherein said detector element comprises a scintillation layer or monocrystalline scintillator.

8. A charged particle beam device according to claim 6 or 7, wherein said detector unit comprises a photonic sensor or solid state direct electron sensor.

9. A charged particle beam device according to claim 6, 7, or 8, wherein said detector unit comprises a lightguide element for direct light coupling of said detector element.

10. A charged particle beam device according to claim 7, 8 and 9, wherein said lightguide element is arranged for direct light coupling of said scintillation layer to said photonic sensor.

11. A charged particle beam device according to claim 9 or 10, wherein said lightguide element extends over a distance of at least 5 mm, in particular at least 10 mm.

12. A charged particle beam device according to claim 1-11, wherein said plurality of detectors is arranged in a corresponding 1D pattern.

13. Method of inspecting a specimen with a plurality of charged particle beamlets, the method comprising the steps of:
- Providing a specimen;
- Providing a plurality of charged particle beamlets and focusing said plurality of charged particle beamlets onto said specimen;
- Detecting a flux of radiation emanating from the specimen in response to said irradiation by said plurality of charged particle beamlets;
**Characterized in that** the method comprises the steps of:
- Directing said plurality of charged particle beamlets onto said specimen in an essentially 1D pattern; and
- Detecting a flux of radiation emanating from the specimen in response to irradiation by an associated one of said plurality of charged particle beamlets.

14. Method according to claim 13, comprising the step of scanning said sample with said charged particle beamlets, in particular by moving said charged particle beamlets onto said specimen in a first direction and concurrently moving said specimen in a second direction substantially orthogonal to said first direction.

15. Method according to claim 13 or 14, wherein detecting a flux of radiation comprises the step of detecting backscattered electrons.

16. Method according to claim 15, wherein a distance between the detector and the specimen is kept constant during inspecting said specimen.

17. Method according to claim 16, wherein a mutual position of the plurality of charged particle beamlets and the corresponding plurality of detector elements is aligned.
